(19) Europäisches Patentamt
European Patent Office
Office européen des brevets

(11) **EP 2 676 530 B1**

(12) **EUROPEAN PATENT SPECIFICATION**

(45) Date of publication and mention of the grant of the patent:
**31.12.2014 Bulletin 2015/01**

(51) Int Cl.:
*H05B 37/02* (2006.01)   *H05B 37/03* (2006.01)
*G01R 31/44* (2006.01)

(21) Application number: **12703855.2**

(22) Date of filing: **16.02.2012**

(86) International application number:
**PCT/EP2012/052726**

(87) International publication number:
**WO 2012/110621 (23.08.2012 Gazette 2012/34)**

(54) **SYSTEM AND METHOD FOR VERIFYING THE OPERATION OF LIGHTING SYSTEMS**

SYSTEM UND VERFAHREN ZUR PRÜFUNG DES BETRIEBS VON BELEUCHTUNGSSYSTEMEN

SYSTÈME ET PROCÉDÉ DE VÉRIFICATION DU FONCTIONNEMENT DE SYSTÈMES D'ÉCLAIRAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.02.2011 IT PD20110046**

(43) Date of publication of application:
**25.12.2013 Bulletin 2013/52**

(73) Proprietor: **Key Word SRL**
**33170 Pordenone (IT)**

(72) Inventor: **ELIA, Ferrandina**
**45100 Rovigo (IT)**

(74) Representative: **Modiano, Micaela Nadia**
**Modiano & Partners (IT)**
**Via Meravigli, 16**
**20123 Milano (IT)**

(56) References cited:
**EP-A1- 0 746 183     EP-A1- 2 262 350**
**EP-A2- 2 012 287**

**Description**

The present invention relates to the field of energy saving, with particular reference to systems and methods for verifying the correct operation of public lighting systems.

As is known, the term energy saving includes various techniques adapted to reduce consumption of the energy necessary to the performance of various human activities. The saving can be obtained in various ways, for example by using technologies that can convert energy from one form to another more efficiently, or by modifying energy processes so that there is less waste.

In particular with regard to public administration, it is essential to monitor and act on energy consumption for public lighting, which, in Italy, represents approximately 55% of a public administration's electricity consumption. In this context the reduction of energy consumption is usually associated with investments with medium/long term amortization.

Specifically for public lighting, some measures are known that make it possible to reduce energy consumption.

The most immediate measure consists in the replacement of traditional mercury lamps with modem lamps using LED or SAP technology. Alternately or in addition, flux regulators can be installed which can be configured so as to vary the intensity of illumination as needed.

These contrivances make it possible to achieve considerable savings. However their effectiveness is limited by the fact that in and of themselves they do not make it possible to overcome waste deriving from malfunctioning of the light sources, in particular from the accidental switching-on of light sources during daylight hours.

In order to contain energy waste it is therefore essential that the illumination be as far as possible in synchrony with the periods of light and dark that vary over the course of the year. Ideally the electricity consumption of a public lighting system should occur exclusively in the hours between dusk and dawn.

As is known, a lighting system is commanded by way of electricity distribution switchboards in which there are circuit breakers to protect the electricity lines, an energy meter, and a control device that governs the switching on and off. The simplest type of control device is the timer, which switches the systems on and off at constant times.

This very cheap solution exhibits the drawback whereby it is necessary to, modify the switching-on and switching-off times at least weekly in order to take account of seasonal variations.

This drawback is not a minor one. It must in fact be kept in mind that public lighting systems are characterized by a great quantity of key points spread throughout the administered territory, and it is necessary to constantly control their operation and perform maintenance on them. In particular in urban areas, public lighting systems are very extensive and widely distributed, and have a very large number of electrical power supply switchboards and, especially, of lights.

In order to manage this complexity, some public administrations have set up telecontrol systems. Such systems make it possible to transmit and receive the main electrical parameters remotely and perform switching-on or switching-off at preset times. Solutions based on telecontrol however exhibit the drawback of being quite expensive both in terms of installation and of management. An example of the aforementioned systems is shown by the European patent application EP 2012 287 A2.

As an alternative to timer-based solutions, optionally telecontrolled, it is is possible to provide each lighting system with a twilight switch, i.e. with a device composed of a probe for measuring light intensity and a light level regulator that drives the switching-on and switching-off threshold. If the twilight switch works correctly, then the consumption of electricity of a public lighting system occurs exclusively in the hours between dusk and dawn. It is a very cheap device, and for this reason it is widely used in public lighting systems.

The use of twilight switches also presents drawbacks, however. In particular these devices are often subject to a deterioration by the action of atmospheric agents which modify the transparency of the outer enclosure following the deposit of dust and the action of heat transmitted by solar rays. For this reason with the passing of time the capacity of the twilight switch to precisely detect the intensity of the light can deteriorate, often leading to early switching-on or late switching-off of the electric circuit connected thereto. This type of malfunctioning can cause a waste of electricity which, if the device is completely broken, can even reach 100% more than the optimum.

In the state of the art the only way to notice the possible malfunctioning of a twilight switch, and as a consequence carry out the repair or replacement thereof, is manual, i.e. visual confirmation is necessary of whether a system is switched on in a time band in which it should be switched off or vice versa. This is not a satisfactory solution, since an extensive use of maintenance personnel is required in order to carry out periodic visits to all the systems, and moreover there is also the risk that intervention is not prompt. In addition the periodic visual inspection does not make it possible to precisely determine for how long the device has been malfunctioning, and thus to quantify the energy waste caused by the malfunction.

From the foregoing it ensues that there is a greatly felt need in the sector of providing a system and a method for verifying the operation of a twilight switch installed in a lighting system which overcomes the above-mentioned limitations of the known art, while providing better performance levels than the state of the art.

The aim of the present invention is to provide a system and a method for verifying the operation of a lighting system which enable automatic and prompt identification of malfunctioning twilight switches.

Within this aim, an object of the present invention is to quantify, in the event of malfunctioning, the excess electricity wasted with respect to how much would have been consumed if the switch had functioned correctly.

Another object of the present invention is to provide a system and a method for verifying the operation of a lighting system which enable automatic and prompt identification of any anomalies in the actual systems, such as for example failures in the light sources.

Last but not least, an object of the present invention is to provide a system and method for verifying the operation of a lighting system which is simple to make, install and maintain, can be easily integrated with preexisting lighting infrastructure, and can be implemented and managed at low cost.

This aim and these and other objects which will become more apparent in the description of the present invention are all achieved by a method according to claim 1.

This aim and these objects are moreover achieved by a system according to claim 9.

Further characteristics and advantages of the invention will become more apparent from the description of a preferred, but not exclusive, embodiment of the system and method for verifying the operation of lighting systems, which is illustrated by way of non-limiting example in the accompanying drawings wherein:

Figure 1 is a block diagram of a possible architecture of the system according to the present invention;
Figure 2 is a block diagram which shows an aspect of the architecture in Figure 1 in greater detail;
Figure 3 is a flowchart which shows a first embodiment of the method for verifying the operation of a lighting system according to the present invention;
Figure 4 is a flowchart which shows a second embodiment of the method for verifying the operation of a lighting system according to the present invention.

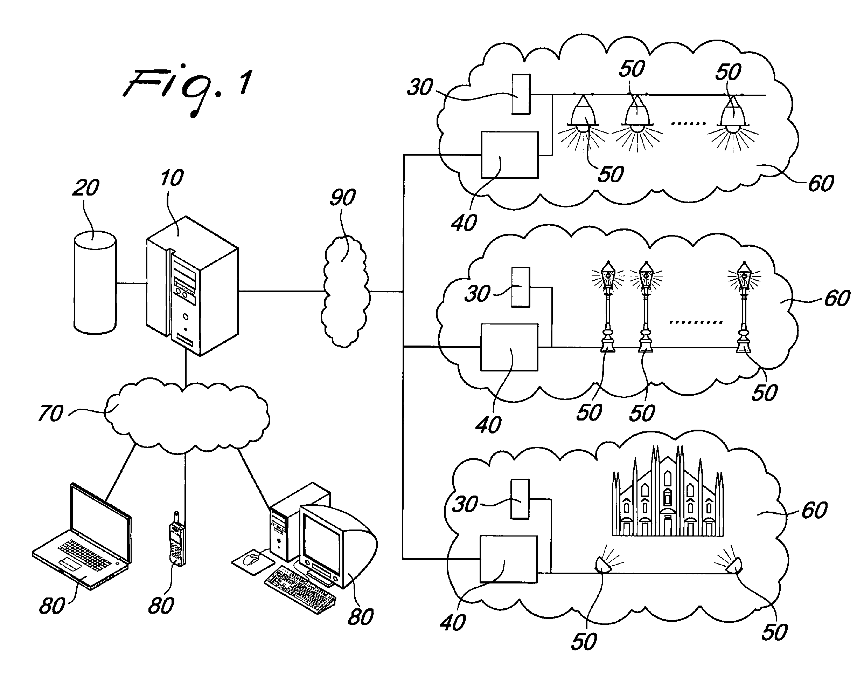

An illustrative architecture of the system for verifying the operation of lighting systems according to the present invention is summed up in the block diagram in Figure 1.

The architecture comprises a central computer 10, a plurality of lighting systems 60, and, optionally, a plurality of devices 80 for interfacing with the central computer 10.

The central computer 10 is a system of the server type, which comprises or has access to means for storage 20, which can comprise for example a database or any data structure adapted to store information permanently.

Each lighting system 60 comprises a twilight switch 30, an energy meter 40 and a plurality of lighting elements 50.

The twilight switch 30 is a conventional device, for example of the electronic or electromechanical type, capable of measuring the intensity of light of the host environment, for example by way of a photoresistor. It is preferably configured to begin operation automatically with the fall of darkness (twilight) and switch off with the break of dawn. The switching on and off of the twilight switch drive, for example by way of a relay, the power supply of the electric circuit to which the lighting elements 50 are connected.

Each lighting element 50 represents a single light source, characterized by a type and by a power. The type of lighting elements can vary from lamppost or suspension lamps for street and urban lighting, to floodlights for lighting up monuments and the like.

Each energy meter is a conventional electronic meter, connected to the respective lighting system 60 and adapted to read the actual consumption of electricity of the lighting system 60. In one embodiment, the energy meter 60 is a meter of the multiphase type, i.e. a device adapted to read the energy consumption in a plurality of time bands. By way of non-limiting example, in Italy this could be a three-phase meter configured for three-hourly readings of electricity consumption according to the time bands specified by Resolution no. 181/2006 of the Italian AEEG (Authority for Electrical Energy and Gas).

The central computer 10 and the electricity meters 40 are provided with interfaces that make it possible to communicate with each other by way of a telematic communications network 90, over which the data read by the electricity meters 40 is sent to the central computer 10 and preferably stored in the storage means 20. The sending can occur in real time or on a periodic basis, and the data can be sent in raw or aggregated form. The central computer 10 could for example be directly connected to each electricity meter 40, or, if there are preexisting communications networks between the electronic meters 40 and centralized data acquisition systems, such as for example in the remote management system used by Enel, the central computer 10 can interface with adapted nodes of such network, for example the concentrators or the central system for remote management.

The central computer 10 is optionally capable of communicating with a plurality of interrogation devices 80. In this case, the central computer 10 and the interrogation devices 80 are provided with interfaces that make it possible to communicate with each other by way of a telematic communications network 70. The network 70 is preferably the internet, but it can also be an intranet or any private network adapted to implement a communications protocol of the client-server type. The network 70 is connected where necessary to mobile networks for communications between central computer 10 and interrogation devices 80.

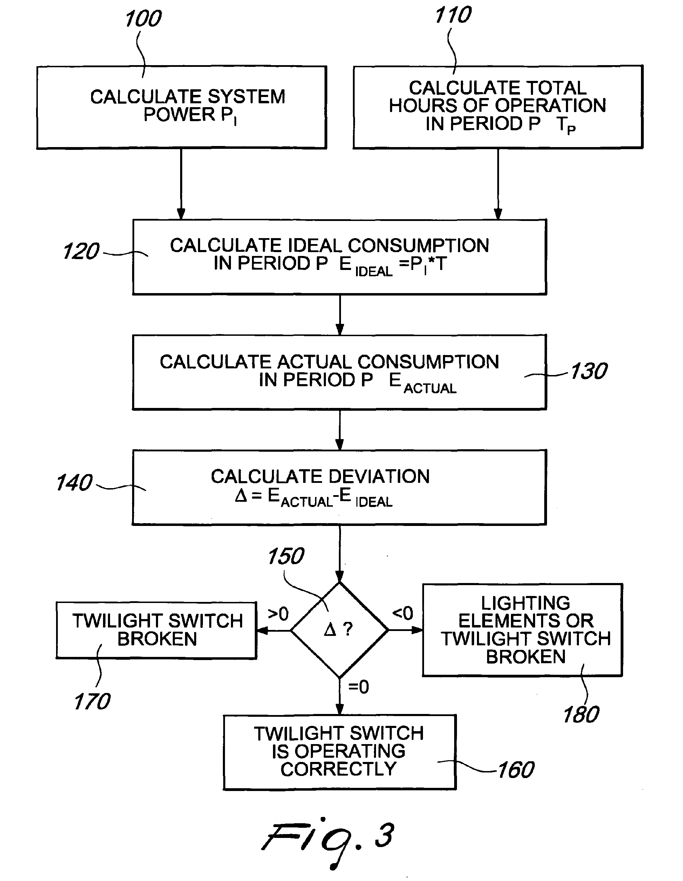

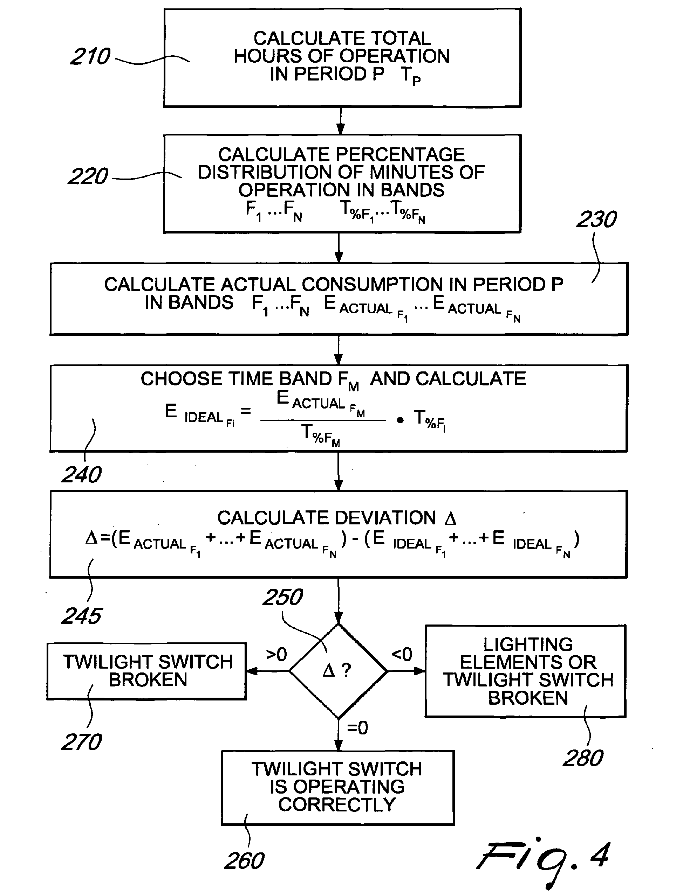

In particular the central computer 10 comprises means for sending various types of notification, depending on the outcome of the verifications performed, to the interrogation devices 80, as will be shown in greater detail with reference to Figures 3 and 4.

Each interrogation device 80 is a device of the client type which is capable of connecting to the central computer 10 by way of the telecommunications network 70. The interrogation device 80 can for example be a personal computer, a cellular phone or a smartphone, if necessary conveniently provided with adapted software for communicating with the central computer 10. The central computer 10 is adapted to communicate with the interrogation devices 80 by a plurality of channels, for example SMS messages, email messages, voice browsing, instant messaging, a web interface or a rich client. The mode of communication between client and server can be of the push type and/or of the pull type. In practice any combination of device and communications protocol adapted to the transport of information between central computer 10 and interrogation devices 80 can be used with the system and the method according to the invention.

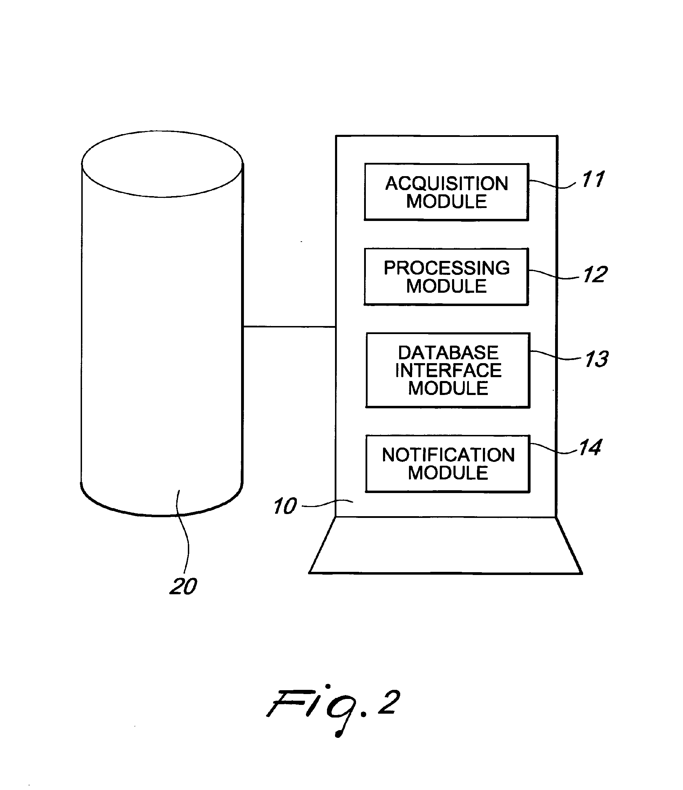

Figure 2 shows the architecture of the central computer 10 according to the invention in Figure 1 in greater detail. The central computer 10 comprises an acquisition module 11, a processing module 12, a module 13 for interfacing with the storage means 20 and a notification module 14.

The acquisition module 11 is a module designed to interface with the electricity meters 40 by way of the telematic communications network 90, as explained previously. In particular the acquisition module 11 takes the data read by the electricity meters 40 and stores it in the storage means 20.

The processing module 12 is a module configured to execute processing of the data stored in the storage means 20, so as to calculate values relating to the ideal and actual consumptions of the lighting system 60 to be verified, as will be explained in more detail hereinbelow.

The module 13 for interfacing with the storage means 20 is a module designed to interface with the processing module 12 in order to receive interrogations therefrom to be submitted to the storage means 20 and in order to return the results of the interrogations thereto.

Finally, the notification module 14 is a module connected to the processing module 12, configured to communicate the outcome of the processing executed by the processing module 12 according to various criteria and channels, as previously explained and as will be further discussed hereinbelow.

With reference to Figure 3, a first embodiment of the method for verifying the operation of a lighting system according to the present invention shall now be illustrated in detail.

In this first embodiment it is assumed that, for each lighting system 60 the operation of which is to be verified, the maximum power withdrawn by the system and the power dissipated by the power supply are known or can be calculated, for example because the number of lighting elements 50, the power of each lighting element, and the power factor of the power supply circuit are known. It is moreover assumed that all the lighting elements 50 are driven by the same twilight switch 30. Finally it is assumed that in the lighting system 60 flux reducers are not installed which are activated in specific time bands only.

The method begins in steps 100 and 110, which can be executed in any order or even, if the central computer 10 is of the multiprocessor type, simultaneously.

In step 100 the central computer tracks or calculates the maximum power withdrawn by the lighting system which is to be verified. In a preferred embodiment the module 13 for interfacing with the storage means accesses the storage means 20 in order to retrieve the characteristics of the system to be evaluated, characteristics which can comprise for example the number of lighting elements and the power of each lighting element, and the reactive power or the power factor of the power supply. Then the module 13 for interfacing with the storage means communicates this data to the processing module 12.

Based on such data, the processing module 12 calculates the apparent power and the overall active power of the system, according to conventional methods. By way of non-limiting example, the processing module 12 performs this calculation by summing up the powers of the individual lighting elements and then multiplying the value obtained by the typical power factor of the system. In an alternative embodiment, the overall active power is directly stored in the storage means 20, and as a consequence it is simply retrieved by the module 13 for interfacing with the storage means and made available to the processing module 12 for subsequent processing. The person skilled in the art will easily comprehend that many alternative calculation variations are possible, corresponding to different choices of distribution between preset data and calculated data.

In step 110 the central computer 10 performs the calculation of the total operation time expected of the lighting system in correct operating conditions of the twilight switch in a specific time period, for example one month. In particular, by way of example, the module 13 for interfacing with the storage means interrogates the storage means 20 in order to retrieve the times of sunrises and sunsets for the place where the system is installed and in the desired time period. Such data is used by the processing module 12 for calculating the total elapsed time between sunsets and sunrises for the specific place and time period. Similarly to what was said with reference to step 100, alternatively such data concerning the duration of daylight and darkness in preset time periods and places could already be present in aggregate or semiaggregate form in the storage means 20. The person skilled in the art will be able to select the best mode of storing such data to meet the desired tradeoff between processing speed and possibility of finer granularity in the choice of the time period. The time thus calculated is therefore the time for which it is presumed that the lighting system should remain switched on, in the specific place and time period, for a successful lighting session.

The total active power calculated in step 100 is multiplied in step 120 with the presumed total activity time calculated in step 110 for calculating the ideal consumption of the lighting system.

In step 130 the actual consumption is read or calculated of the same system installation in the same specific time period, for example the previous month. As mentioned previously, such actual consumption can be deduced from the data read and made available by the electronic meter 40 according to conventional methods.

In step 140 the processing module 12 calculates the deviation, i.e. the algebraic difference, between the actual consumption determined in step 130 and the ideal consumption determined in step 120. Such deviation is sent to the notification module 14, which in step 150 decides whether, how, and to whom the outcome of the verification should be transmitted, based on the value of such deviation.

In particular if the deviation has a nil value, this is indicative that the actual consumption coincides with the ideal consumption and thus of correct operation of the twilight switch. In this case in step 160 the notification module can be configured not to send any notification, or alternatively to send informative notifications according to the channels and protocols mentioned previously with reference to Figure 1. Possible recipients of such notifications are for example people like the energy managers of the public administrations where the system being verified is installed.

If the deviation has a positive value, i.e. the actual consumption is higher than the ideal consumption, this is indicative of a malfunctioning twilight switch, which has caused an early switching-on and/or a late switching-off of the lighting system connected thereto.

In this case in step 170 the notification module can be configured to send notifications, as well as to administrative staff, also to personnel entrusted with repairing and/or replacing twilight switches, for an optional field verification. In a preferred embodiment the notifications will comprise not only the positive sign of the deviation but also the extent of the deviation, so as to provide more circumstantial information to the personnel entrusted with planning the repair or replacement operations. For example if the deviation is slight it could be decided to defer a replacement operation, which would be carried out more rapidly in case of a large deviation.

Finally if the deviation has a negative value, i.e. the actual consumption is lower than the ideal consumption, this could be indicative of a malfunctioning twilight switch that has caused a late switching-on and/or an early switching-off of the lighting system connected thereto, or that one or more lighting elements are broken, and as a consequence the overall active power is reduced. In this case in step 180 the notification module can be configured to send notifications, as well as to administrative staff, also to personnel entrusted with maintenance of lighting systems, for an optional field verification. Similarly to the previous case of a positive deviation, in a preferred embodiment the notifications comprise not only the negative sign of the deviation but also the extent of the deviation, so as to provide more exact information about the urgency of maintenance operations.

For a better understanding of the first embodiment of the method for verifying the operation of a lighting system according to the invention, a purely illustrative example is given below.

Consider a lighting system I with the following characteristics:

- the system comprises 4 lighting elements $L_1$.. $L_4$, each one characterized by a corresponding power $P_1$.. $P_4$;
- all power levels are 0.15 kW;
- the power factor $\cos\varphi$ of the system is 0.9
- it is desired to carry out the verification in the month of September
- the system is installed in Rome, a geographic location characterized in the month of September respectively by dawn times of $T_{a1}...T_{a30}$ and by dusk times of $T_{t1}.... T_{t30}$;
- the total number of hours that elapse between dusk and dawn in Rome in the month of September is retrieved or calculated as being:

$$T_{\text{tot month}} = 344 \text{ h}$$

- the actual consumption of the system I read in the month of September is $E_{\text{actual}} = 250$ kWh.

By following the steps of the method previously described, we obtain:

$$P_{tot}[kW] = \sum_{i=1}^{4} P_i = 0.6 \, kW$$

$$P_{\text{active}}[kW] = P_{\text{tot}}[kW] * \cos\varphi = 0.6*0.9 = 0.54 \ kW$$

$$E_{ideal}[kWh] = P_{active}[kW] * T_{tot \ month}[h] = 0.54*344 = 185.76 \ kWh$$

$$\Delta[kWh] = E_{actual}[kWh] - E_{ideal}[kWh] = 250 - 185.76 = 64.24 \ kWh$$

In this example the result of the verification, i.e. a positive deviation, indicates a malfunctioning of the twilight switch.

With reference to Figure 4, a second embodiment of the method for verifying the operation of a lighting system according to the present invention shall now be illustrated in detail.

In this second embodiment it is assumed that the active power of the lighting system 60, the operation of which is to be verified, is neither known nor can be calculated. It is likewise assumed that the energy meter 40 connected to the lighting system 60 is an electronic meter of the multiphase type, i.e. a device that is adapted to record the energy consumption levels in a plurality of time bands $F_1...F_{No.}$, as previously described. Finally, similarly to the first embodiment described previously, it is assumed that all the lighting elements 50 comprised in the lighting system 60 are driven by the same twilight switch 30 and that in the lighting system 60 flux reducers are not installed which are activated in specific time bands only.

The method begins in step 210, in which the central computer 10 performs the calculation of the total operation time $T_{tot}$ expected of the lighting system under correct operating conditions of the twilight switch in a specific time period, according to the methods previously described with reference to step 110 of Figure 3.

In step 220, for each time band $F_I$, the processing module 12 calculates, based on the times of sunsets and sunrises in the specific place and time period stored in the storage means 20, the sum of the minutes of operation of the system in that band, $T_{FI}$.

The processing module 12 thus calculates, for each time band $F_I$, the percentage distribution $T_{\%FI}$ of the minutes of operation in that band in the period in question on the basis of the total period calculated in step 210, i.e. $T_{\%FI} = T_{FI} / T_{tot}$.

In step 230 the actual consumption is read or calculated, for each time band $F_I$ of the same system installation in that band in the same specific time period, for example the previous month. As mentioned previously, such actual consumption can be deduced from the data read and made available by the electronic meter 40 according to conventional methods. Thus we obtain N values of actual consumption $E_{actualF1} \cdots E_{actualFN}$.

In step 240 the processing module 12 infers the ideal consumption, for each time band $F_I$, of the same system installation in that band in the same specific time period, for example the previous month, even though there is no information concerning the power used by the system. In particular, first the processing module 12 chooses, from the set of bands $F_1...F_N$, a specific band $F_M$ for which it is assumed that the actual consumption is equal to the ideal consumption. In a preferred embodiment such band $F_M$ is characterized in that it is entirely comprised in the hours between dusk and dawn in the period in question, i.e. it is a band during which it is assumed that the system should always be switched on. By way of example, using the AEEG bands as a reference, we could consider the $F_3$ band.

Once the reference time band $F_M$ has been determined, the processing module 12 calculates the ideal consumption in every other band $F_I$ by relating it to the one of the selected reference band, i.e. by dividing the actual consumption in the time band $F_M$ by the percentage for the same band $T_{\%FM}$ and multiplying by the percentage of minutes of operation $T_{\%FI}$ calculated for the band $F_1$, according to the formula:

$$E_{idealFI} = \frac{E_{actualFM}}{T_{\%FM}} * T_{\%FI}$$

In step 245, the processing module 12 calculates the deviation, i.e. the algebraic difference, between the total actual consumption, i.e. summed up over all the bands, determined in step 230, and the total ideal consumption, i.e. summed up over all the bands, inferred in step 240. Such deviation is sent to the notification module 14, which in step 250 decides whether, how and to whom the outcome of the verification is to be transmitted on the basis of the value of such deviation, with similar methods, in steps 260, 270 and 280, to those previously described with reference to steps 160, 170 and 180 in Figure 3.

For a better understanding of the second embodiment of the method for verifying the operation of a lighting system according to the invention now shown, a purely illustrative example is given below.

- it is desired to carry out the verification in the month of September
- the system is installed in Rome;
- the energy meter 40 is configured to read the AEEG time bands $F_1$, $F_2$ and $F_3$.

The meter 40 has read the following actual consumptions for the month of September, subdivided by AEEG band:

$$E_{actualF1} = 17 \text{ kWh},$$

$$E_{actualF2} = 110 \text{ kWh},$$

$$E_{actualF3} = 219.9 \text{ kWh}$$

The total number of hours that elapse between dusk and dawn in Rome in the month of September is retrieved or calculated, as in the previous example, as being $T_{average} = 344$ h.

By following the steps of the method previously described, we obtain:

$$T_{\%F3} = \frac{T_{F3}}{T_{average}} * 100 = \frac{223.1}{344} * 100 = 64.85\%$$

$$T_{\%F2} = \frac{T_{F2}}{T_{average}} * 100 = \frac{106.6}{344} * 100 = 30.99\%$$

$$T_{\%F1} = \frac{T_{F1}}{T_{average}} * 100 = \frac{14.3}{344} * 100 = 4.16\%$$

$$E_{idealF3} = \frac{E_{actualF3}}{T_{\%F3}} * T_{\%F3} = \frac{219.9}{64.85} * 64.85 = 219.9 \, kWh$$

$$E_{idealF2} = \frac{E_{actualF3}}{T_{\%F3}} * T_{\%F2} = \frac{219.9}{64.85} * 30.99 = 105.08 \, kWh$$

$$E_{idealF1} = \frac{E_{actualF3}}{T_{\%F3}} * T_{\%F1} = \frac{219.9}{64.85} * 4.16 = 14.10 \, kWh$$

$$\Delta = (E_{actualF1} + E_{actualF2} + E_{actualF3}) - (E_{idealF1} + E_{idealF2} + E_{idealF3})$$

$$\Delta = (17 + 110 + 219.9) - (14.10 + 105.08 + 219.9) = 7.82$$

In this example the outcome of the verification would indicate a malfunctioning of the twilight switch.

Thus it has been shown that the present invention achieves the intended aim and objects. In particular, it has been shown that the system and the method thus conceived make it possible to overcome the qualitative limitations of the known art thanks to the fact that it automatically verifies the operation of the twilight switches and at the same time quantifies, in the event of malfunctioning, the energy waste which has occurred.

It has likewise been shown that the invention is practical for implementation, installation and maintenance, since it requires standard hardware/software components and simple interfaces for integration with the infrastructure of the preexisting public lighting network.

The system according to the invention can be moreover validly used for private applications as well as for public applications.

By way of example, the person skilled in the art will effortlessly comprehend that it is possible to produce a variation of the two embodiments previously illustrated which is obtained by the combination thereof, i.e. a verification system and a method capable of discerning, for each system to be verified, whether the data relating to the power of the system and/or the data relating to the consumption in the time bands is known, and selecting the deviation calculation method as a consequence.

**Claims**

1. A method for verifying the operation of one or more lighting systems (60), each lighting system (60) comprising a twilight switch (30) adapted to supply power to the electric circuit of said lighting system (60) and an electronic power meter (40) adapted to record information relating to the power consumed by said lighting system (60) in a specific time period and in one or more preset time bands, configured to cover all of said specific time period, said method being **characterised in that** it comprises the steps of:

    a) determining (110, 210) an expected total operating time $T_P$ of said lighting system (60) in said specific time period, on the basis of information relating to the times of sunrises and sunsets in said specific time period in the installation location of said lighting system (60);
    b) determining (130, 230), for each time band of said one or more preset time bands, an actual consumption of said lighting system (60) in said specific time period in said time band, on the basis of said information recorded by said electronic power meter (40);
    c) determining (120, 240), for each time band of said one or more preset time bands, an ideal consumption of said lighting system (60) in said specific time period in said time band, on the basis of said expected total operating time $T_P$ determined in step a);
    d) comparing (140, 245) the sum of the actual consumptions determined in step b) and the sum of the ideal consumptions determined in step c); and
    e) determining (250, 260, 270, 280) operating conditions of said lighting system (60) on the basis of the outcome of said comparison.

2. The method according to claim 1, **characterized in that**:

    - said electronic power meter (40) is adapted to record information relating to the power consumed by said lighting system (60) in a single preset time band; and
    - said step c) of determining (120) said ideal consumption in said single time band in said preset time period is performed on the basis of information relating to the active power $P_I$ of said lighting system (60).

3. The method according to claim 2, wherein said step c) of determining (120) said ideal consumption in said single time band in said specific time period comprises calculating said ideal consumption according to the formula: $E_{ideal} = P_I * T_P$.

4. The method according to claim 1, **characterized in that**:

    - said electronic power meter (40) is adapted to record information relating to the power consumed by said lighting system (60) in a plurality of preset time bands;

- said step c) of determining (240) said plurality of ideal consumptions in said plurality of time bands in said specific time period is performed on the basis of information relating to said plurality of actual consumptions determined in step b).

5. The method according to claim 4, wherein said step c) of determining (240) said ideal consumption $E_{idealFI}$ for each time band FI of said plurality of time bands in said specific time period comprises the steps of:

   c1) calculating (220), for each time band $F_I$ of said plurality of time bands, the percentage distribution $T_{\%FI}$ of the operating time of said lighting system (60) in said time band and in said specific time period, on the basis of said expected total operating time $T_P$ determined in step a) and said actual consumption $E_{actualFI}$ determined in step b) of said lighting system (60) in said time band and in said specific time period;
   c2) selecting (240) a time band $F_M$ of said plurality of time bands and assuming $E_{idealFM} = E_{actualFM}$; and
   c3) calculating (240) said ideal consumption $E_{idealFI}$ for every other time band $F_I$ on the basis of said actual consumption in said time band $F_M$ and said percentage distributions $T_{\%FI}$ and $T_{\%FM}$ determined in step c1).

6. The method according to claim 5, wherein said time band $F_M$ selected in step c2 is **characterized in that** in said specific time period and in said installation location the expected operating time of said lighting system (60) in said time band $F_M$ substantially coincides with the total time duration of said time band $F_M$.

7. The method according to one or more of the preceding claims, wherein in said step d) of comparing (140, 245) said sum of the actual consumptions determined in step b) and said sum of the ideal consumptions determined in step c) comprises calculating the difference between the sum of said actual consumptions and the sum of said ideal consumptions.

8. The method according to claim 7, wherein said step e) of determining (250, 260, 270, 280) operating conditions of said lighting system (60) on the basis of the outcome of said comparison comprises the steps of:

   - determining whether said difference between said sum of said actual consumptions and said sum of said ideal consumptions is nil, positive or negative;
   - if said difference is nil, determining that said lighting system (60) is operating correctly;
   - if said difference is positive, determining that said twilight switch (30) is malfunctioning; and
   - if said difference is negative, determining that said twilight switch (30) or said lighting system is malfunctioning.

9. A system for verifying the operation of one or more lighting systems (60), each lighting system (60) comprising a twilight switch (30) adapted to supply power to the electric circuit of said lighting system (60) and an electronic power meter (40) adapted to record information relating to the power consumed by said lighting system (60) in a specific time period and in one or more preset time bands configured to cover all of said specific time period, said verification system being **characterised in that** it comprises:

   processing means (10), configured to:

   a) determine (110, 210) an expected total operating time $T_P$ of said lighting system (60) in said specific time period, on the basis of information relating to the times of sunrises and sunsets in said specific time period in the installation location of said lighting system (60);
   b) determine (130, 230), for each time band of said one or more preset time bands, an actual consumption of said lighting system (60) in said specific time period in said time band, on the basis of said information recorded by said electronic power meter (40);
   c) determine (120, 240), for each time band of said one or more preset time bands, an ideal consumption of said lighting system (60) in said specific time period in said time band, on the basis of said expected total operating time determined in step a);
   d) compare (140, 245) the sum of the actual consumptions determined in step b) with the sum of the ideal consumptions determined in step c); and
   e) determine (250, 260, 270, 280) operating conditions of said lighting system (60) on the basis of the outcome of said comparison.

10. The system according to claim 9, furthermore comprising storage means (20), which are adapted to store said information relating to times of sunrises and sunsets in said specific time period in the installation location of said lighting system (60) and said information recorded by said electronic power meter (40).

**11.** The system according to claim 10, **characterized in that**:

- said electronic power meter (40) is adapted to record information relating to the power consumed by said lighting system (60) in a single preset time band; and
- said storage means (20) are adapted to store information relating to the active power $P_I$ of said lighting system (60).

**12.** The system according to claim 10, **characterized in that**:

- said electronic power meter (40) is adapted to record information relating to the power consumed by said lighting system (60) in a plurality of preset time bands;
- said processing means (10) are configured to determine said plurality of ideal consumptions in said plurality of time bands in said specific time period on the basis of information relating to said plurality of actual consumptions.

## Patentansprüche

**1.** Ein Verfahren zur Überprüfung des Betriebs von einem oder mehreren Beleuchtungssystemen (60), wobei jedes Beleuchtungssystem (60) einen Dämmerungsschalter (30) umfasst, ausgebildet, um dem elektrischen Schaltkreis des Beleuchtungssystems (60) Strom zuzuführen, und einen elektronischen Leistungsmesser (40), ausgebildet, um Informationen bezüglich der Leistung zu erfassen, die von dem Beleuchtungssystem (60) in einem bestimmten Zeitraum und in einer oder mehreren voreingestellten Randzeiten verbraucht wird, konfiguriert, um den gesamten bestimmten Zeitraum abzudecken, wobei das Verfahren **dadurch gekennzeichnet ist, dass** es folgende Schritte umfasst:

a) Bestimmung (110, 210) einer erwarteten Gesamtbetriebszeit $T_P$ des Beleuchtungssystems (60) in dem bestimmten Zeitraum auf der Grundlage von Informationen bezüglich der Zeiten von Sonnenaufgang und Sonnenuntergang in dem bestimmten Zeitraum an dem Installationsort des Beleuchtungssystems (60);
b) Bestimmung (130, 230), für jede Randzeit der einen oder mehreren voreingestellten Randzeiten, eines tatsächlichen Verbrauchs des Beleuchtungssystems (60) in dem bestimmten Zeitraum in der Randzeit auf der Grundlage der Informationen, die von dem elektronischen Leistungsmesser (40) erfasst werden;
c) Bestimmung (120, 240), für jede Randzeit der einen oder mehreren voreingestellten Randzeiten, eines idealen Verbrauchs des Beleuchtungssystems (60) in dem bestimmten Zeitraum in der Randzeit auf der Grundlage der erwarteten Gesamtbetriebszeit $T_P$, die in Schritt a) bestimmt wurde;
d) Vergleichen (140, 245) der Summe der tatsächlichen in Schritt b) bestimmten Verbräuche und der Summe der idealen in Schritt c) bestimmten Verbräuche; und
e) Bestimmung (250, 260, 270, 280) von Betriebsbedingungen des Beleuchtungssystems (60) anhand des Ergebnisses des Vergleichs.

**2.** Das Verfahren gemäß Anspruch 1, **dadurch gekennzeichnet, dass**:

- der elektronische Leistungsmesser (40) ausgebildet ist, um Informationen bezüglich der Leistung zu erfassen, die von dem Beleuchtungssystem (60) in einer einzigen voreingestellten Randzeit verbraucht wird; und
- der Schritt c) der Bestimmung (120) des idealen Verbrauchs in der einzigen Randzeit in dem voreingestellten Zeitraum auf der Grundlage von Informationen bezüglich der aktiven Leistung $P_1$ des Beleuchtungssystems (60) durchgeführt wird.

**3.** Das Verfahren gemäß Anspruch 2, worin der Schritt c) der Bestimmung (120) des idealen Verbrauchs in der einzigen Randzeit in dem bestimmten Zeitraum die Berechnung des idealen Verbrauchs nach der Formel: $E_{ideal} = P_1 * Tp$ umfasst.

**4.** Das Verfahren gemäß Anspruch 1, **dadurch gekennzeichnet, dass**:

- der elektronische Leistungsmesser (40) ausgebildet ist, um Informationen bezüglich der Leistung, die von dem Beleuchtungssystem (60) verbraucht wird, in einer Vielzahl voreingestellter Randzeiten zu erfassen;
- der Schritt c) der Bestimmung (240) der Vielzahl idealer Verbräuche in der Vielzahl von Randzeiten in dem bestimmten Zeitraum anhand von Informationen durchgeführt wird, die die Vielzahl tatsächlicher Verbräuche, die in Schritt b) bestimmt wurden, betreffen.

5. Das Verfahren gemäß Anspruch 4, worin der Schritt (c) der Bestimmung (240) des idealen Verbrauchs $E_{idealFI}$ für jede Randzeit FI der Vielzahl von Randzeiten in dem bestimmten Zeitraum folgende Schritte umfasst:

c1) Berechnung (220), für jede Randzeit $F_I$ der Vielzahl von Randzeiten, der prozentualen Verteilung $T_{\%FI}$ der Betriebszeit des Beleuchtungssystems (60) in der Randzeit und in dem bestimmten Zeitraum auf der Grundlage der erwarteten Gesamtbetriebszeit $T_P$, die in Schritt a) bestimmt wurde, und des tatsächlichen Verbrauchs $E_{actualFI}$, der in Schritt b) des Beleuchtungssystems (60) in der Randzeit und in dem bestimmten Zeitraum bestimmt wurde;
c2) Auswahl (240) einer Randzeit $F_M$ der Vielzahl von Randzeiten unter der Annahme, dass $E_{idealFM} = E_{actualFM}$; und
c3) Berechnung (240) des idealen Verbrauchs $E_{idealFI}$ für jede andere Randzeit $F_I$ auf der Grundlage des tatsächlichen Verbrauchs in der Randzeit $F_M$ und der prozentualen Verteilungen $T_{\%FI}$ und $T_{\%FM}$, die in Schritt c1) bestimmt wurden.

6. Das Verfahren gemäß Anspruch 5, worin die in Schritt c2 gewählte Randzeit $F_M$ **dadurch gekennzeichnet ist, dass** in dem bestimmten Zeitraum und an dem Installationsort die erwartete Betriebszeit des Beleuchtungssystems (60) in der Randzeit $F_M$ im Wesentlichen mit der gesamten Zeitdauer der Randzeit $F_M$ übereinstimmt.

7. Das Verfahren gemäß einem oder mehreren der obigen Ansprüche, worin in dem Schritt d) des Vergleichens (140, 245) der Summe der in Schritt b) bestimmten tatsächlichen Verbräuche und der Summe der in Schritt c) bestimmten idealen Verbräuche die Berechnung des Unterschieds zwischen der Summe der tatsächlichen Verbräuche und der Summe der idealen Verbräuche umfasst.

8. Das Verfahren gemäß Anspruch 7, worin der Schritt e) der Bestimmung (250, 260, 270, 280) der Betriebsbedingungen des Beleuchtungssystems (60) auf der Grundlage des Ergebnisses des Vergleichs folgende Schritte umfasst:

- Bestimmung, ob der Unterschied zwischen der Summe der tatsächlichen Verbräuche und der Summe der idealen Verbräuche gleich null, positiv oder negativ ist;
- wenn der Unterschied gleich null ist, Feststellung, dass das Beleuchtungssystem (60) korrekt arbeitet;
- wenn der Unterschied positiv ist, Feststellung, dass der Dämmerungsschalter (30) nicht korrekt arbeitet; und
- wenn der Unterschied negativ ist, Bestimmung, dass der Dämmerungsschalter (30) oder das Beleuchtungssystem nicht korrekt arbeiten.

9. Ein System zur Überprüfung des Betriebs eines oder mehrerer Beleuchtungssysteme (60), wobei jedes Beleuchtungssystem (60) einen Dämmerungsschalter (30) umfasst, ausgebildet, um dem elektrischen Schaltkreis des Beleuchtungssystems (60) Strom zuzuführen, und einen elektronischen Leistungsmesser (40), ausgebildet, um Informationen bezüglich der Leistung zu erfassen, die von dem Beleuchtungssystem (60) in einem bestimmten Zeitraum und in einer oder mehreren voreingestellten Randzeiten verbraucht wird, konfiguriert, um den gesamten bestimmten Zeitraum abzudecken, wobei das Überprüfungssystem **dadurch gekennzeichnet ist, dass** es Folgendes umfasst:

Verarbeitungsmittel (10), ausgebildet, um:

a) eine erwartete Gesamtbetriebszeit $T_P$ des Beleuchtungssystems (60) in dem bestimmten Zeitraum auf der Grundlage von Informationen bezüglich der Zeiten von Sonnenaufgang und Sonnenuntergang in dem bestimmten Zeitraum an dem Installationsort des Beleuchtungssystems (60) zu bestimmen (110, 210);
b) für jede Randzeit der einen oder mehreren voreingestellten Randzeiten einen tatsächlichen Verbrauch des Beleuchtungssystems (60) in dem bestimmten Zeitraum in der Randzeit auf der Grundlage der Informationen, die von dem elektronischen Leistungsmesser (40) erfasst werden, zu bestimmen (130, 230);
c) für jede Randzeit der einen oder mehreren voreingestellten Randzeiten einen idealen Verbrauch des Beleuchtungssystems (60) in dem bestimmten Zeitraum in der Randzeit auf der Grundlage der erwarteten Gesamtbetriebszeit, die in Schritt a) bestimmt wurde, zu bestimmen (120, 240);
d) die Summe der in Schritt b) bestimmten tatsächlichen Verbräuche mit der Summe der idealen in Schritt c) bestimmten Verbräuche zu vergleichen (140, 245); und
e) die Betriebsbedingungen des Beleuchtungssystems (60) anhand des Ergebnisses des Vergleichs zu bestimmen (250, 260, 270, 280).

**10.** Das System gemäß Anspruch 9, das weiter Speichermittel (20) umfasst, die ausgebildet sind, um die Informationen bezüglich der Zeiten von Sonnenaufgang und Sonnenuntergang in dem bestimmten Zeitraum am Installationsort des Beleuchtungssystems (60) und die Informationen, die von dem elektronischen Leistungsmesser (40) erfasst wurden, zu speichern.

**11.** Das System gemäß Anspruch 10, **dadurch gekennzeichnet, dass**:

- der elektronische Leistungsmesser (40) ausgebildet ist, um Informationen bezüglich der Leistung, die von dem Beleuchtungssystem (60) in einer einzigen voreingestellten Randzeit verbraucht wird, zu erfassen; und
- die Speichermittel (20) ausgebildet sind, um Informationen bezüglich der Wirkleistung $P_I$ des Beleuchtungssystems (60) zu speichern.

**12.** Das System gemäß Anspruch 10, **dadurch gekennzeichnet, dass**:

- der elektronische Leistungsmesser (40) ausgebildet ist, um Informationen bezüglich der Leistung, die von dem Beleuchtungssystem (60) in einer Vielzahl voreingestellter Randzeiten verbraucht wird, zu erfassen;
- die Verarbeitungsmittel (10) konfiguriert sind, um die Vielzahl idealer Verbräuche in der Vielzahl von Randzeiten in dem bestimmten Zeitraum auf der Grundlage von Informationen zu bestimmen, die die Vielzahl tatsächlicher Verbräuche betreffen.

## Revendications

**1.** Procédé de vérification du fonctionnement d'un ou plusieurs systèmes d'éclairage (60), chaque système d'éclairage (60) comprenant un interrupteur crépusculaire (30) apte à fournir de l'énergie au circuit électrique dudit système d'éclairage (60) et un compteur de puissance électronique (40) apte à enregistrer des informations connexes à la puissance consommée par ledit système d'éclairage (60) au cours d'une période de temps spécifique et dans une ou plusieurs plages horaires prédéfinies, configurées de manière à couvrir la totalité de ladite période de temps spécifique, ledit procédé étant **caractérisé en ce qu'**il comprend les étapes ci-dessous consistant à :

a) déterminer (110, 210) un temps de fonctionnement total prévu $T_P$ dudit système d'éclairage (60) au cours de ladite période de temps spécifique, sur la base d'informations relatives aux heures de levers et de couchers de soleil au cours de ladite période de temps spécifique dans l'emplacement d'installation dudit système d'éclairage (60) ;
b) déterminer (130, 230), pour chaque plage horaire de ladite une ou desdites plusieurs plages horaires prédéfinies, une consommation réelle dudit système d'éclairage (60) au cours de ladite période de temps spécifique dans ladite plage horaire, sur la base desdites informations enregistrées par ledit compteur de puissance électronique (40) ;
c) déterminer (120, 240), pour chaque plage horaire de ladite une ou desdites plusieurs plages horaires prédéfinies, une consommation idéale dudit système d'éclairage (60) au cours de ladite période de temps spécifique dans ladite plage horaire, sur la base dudit temps de fonctionnement total prévu $T_P$ déterminé à l'étape a) ;
d) comparer (140, 245) la somme des consommations réelles déterminées à l'étape b) et la somme des consommations idéales déterminées à l'étape c) ; et
e) déterminer (250, 260, 270, 280) des états de fonctionnement dudit système d'éclairage (60) sur la base du résultat de ladite comparaison.

**2.** Procédé selon la revendication 1, **caractérisé en ce que** :

- ledit compteur de puissance électronique (40) est apte à enregistrer des informations connexes à la puissance consommée par ledit système d'éclairage (60) dans une plage horaire prédéfinie unique ; et
- ladite étape c) de détermination (120) de ladite consommation idéale dans ladite plage horaire unique au cours de ladite période de temps prédéfinie est mise en oeuvre sur la base d'informations connexes à la puissance active $P_I$ dudit système d'éclairage (60).

**3.** Procédé selon la revendication 2, dans lequel ladite étape c) de détermination (120) de ladite consommation idéale dans ladite plage horaire unique au cours de ladite période de temps spécifique comprend le calcul de ladite consommation idéale selon la formule : $E_{ideal} = P_I * T_P$.

**4.** Procédé selon la revendication 1, **caractérisé en ce que** :

- ledit compteur de puissance électronique (40) est apte à enregistrer des informations connexes à la puissance consommée par ledit système d'éclairage (60) dans une pluralité de plages horaires prédéfinies ;
- ladite étape c) de détermination (240) de ladite pluralité de consommations idéales dans ladite pluralité de plages horaires au cours de ladite période de temps spécifique est mise en oeuvre sur la base d'informations connexes à ladite pluralité de consommations réelles déterminées à l'étape b).

**5.** Procédé selon la revendication 4, dans lequel ladite étape c) de détermination (240) de ladite consommation idéale $E_{idealFI}$ pour chaque plage horaire $F_I$ de ladite pluralité de plages horaires au cours de ladite période de temps spécifique comprend les étapes ci-dessous consistant à :

c1) calculer (220), pour chaque plage horaire $F_I$ de ladite pluralité de plages horaires, la répartition en pourcentage $T_{\%FI}$ du temps de fonctionnement dudit système d'éclairage (60) dans ladite plage horaire et au cours de ladite période de temps spécifique, sur la base dudit temps de fonctionnement total prévu $T_P$ déterminé à l'étape a) et de ladite consommation réelle $E_{actualFI}$ déterminée à l'étape b) dudit système d'éclairage (60), dans ladite plage horaire et au cours de ladite période de temps spécifique ;
c2) sélectionner (240) une plage horaire $F_M$ de ladite pluralité de plages horaires et supposer que $E_{idealFM} = E_{actualFM}$ ; et
c3) calculer (240) ladite consommation idéale $E_{idealFI}$ pour chaque autre plage horaire $F_I$ sur la base de ladite consommation réelle dans ladite plage horaire $F_M$ et desdites répartitions en pourcentage $T_{\%FI}$ et $T_{\%FM}$ déterminées à l'étape c1).

**6.** Procédé selon la revendication 5, dans lequel ladite plage horaire $F_M$ sélectionnée à l'étape c2 est **caractérisée en ce que**, au cours de ladite période de temps spécifique et dans ledit emplacement d'installation, le temps de fonctionnement prévu dudit système d'éclairage (60) dans ladite plage horaire $F_M$ coïncide sensiblement avec la durée temporelle totale de ladite plage horaire $F_M$.

**7.** Procédé selon l'une ou plusieurs des revendications précédentes, dans lequel, à ladite étape d), la comparaison (140, 245) de ladite somme des consommations réelles déterminées à l'étape b) et de ladite somme des consommations idéales déterminées à l'étape c) comprend le calcul de la différence entre la somme desdites consommations réelles et la somme desdites consommations idéales.

**8.** Procédé selon la revendication 7, dans lequel ladite étape e) de détermination (250, 260, 270, 280) des états de fonctionnement dudit système d'éclairage (60) sur la base du résultat de ladite comparaison comprend les étapes ci-dessous consistant à :

- déterminer si ladite différence entre ladite somme desdites consommations réelles et ladite somme desdites consommations idéales est nulle, positive ou négative ;
- si ladite différence est nulle, déterminer que ledit système d'éclairage (60) fonctionne correctement ;
- si ladite différence est positive, déterminer que ledit interrupteur crépusculaire (30) présente un dysfonctionnement ; et
- si ladite différence est négative, déterminer que ledit interrupteur crépusculaire (30) ou ledit système d'éclairage présente un dysfonctionnement.

**9.** Système destiné à vérifier le fonctionnement d'un ou plusieurs systèmes d'éclairage (60), chaque système d'éclairage (60) comprenant un interrupteur crépusculaire (30) apte à fournir de l'énergie au circuit électrique dudit système d'éclairage (60) et un compteur de puissance électronique (40) apte à enregistrer des informations connexes à la puissance consommée par ledit système d'éclairage (60) au cours d'une période de temps spécifique et dans une ou plusieurs plages horaires prédéfinies configurées de manière à couvrir la totalité de ladite période de temps spécifique, ledit système de vérification étant **caractérisé en ce qu'**il comprend :

des moyens de traitement (10) configurés de manière à :

a) déterminer (110, 210) un temps de fonctionnement total prévu $T_P$ dudit système d'éclairage (60) au cours de ladite période de temps spécifique, sur la base d'informations relatives aux heures de levers et de couchers de soleil au cours de ladite période de temps spécifique dans l'emplacement d'installation dudit système d'éclairage (60) ;

b) déterminer (130, 230), pour chaque plage horaire de ladite une ou desdites plusieurs plages horaires prédéfinies, une consommation réelle dudit système d'éclairage (60) au cours de ladite période de temps spécifique dans ladite plage horaire, sur la base desdites informations enregistrées par ledit compteur de puissance électronique (40) ;

c) déterminer (120, 240), pour chaque plage horaire de ladite une ou desdites plusieurs plages horaires prédéfinies, une consommation idéale dudit système d'éclairage (60) au cours de ladite période de temps spécifique dans ladite plage horaire, sur la base dudit temps de fonctionnement total prévu déterminé à l'étape a) ;

d) comparer (140, 245) la somme des consommations réelles déterminées à l'étape b) et la somme des consommations idéales déterminées à l'étape c) ; et

e) déterminer (250, 260, 270, 280) des états de fonctionnement dudit système d'éclairage (60) sur la base du résultat de ladite comparaison.

10. Système selon la revendication 9, comprenant en outre des moyens de stockage (20) qui sont aptes à stocker lesdites informations connexes à des heures de levers et de couchers de soleil au cours de ladite période de temps spécifique dans l'emplacement d'installation dudit système d'éclairage (60), et lesdites informations enregistrées par ledit compteur de puissance électronique (40).

11. Système selon la revendication 10, **caractérisé en ce que** :

- ledit compteur de puissance électronique (40) est apte à enregistrer des informations connexes à la puissance consommée par ledit système d'éclairage (60) dans une plage horaire prédéfinie unique ; et
- lesdits moyens de stockage (20) sont aptes à stocker des informations connexes à la puissance active $P_I$ dudit système d'éclairage (60).

12. Système selon la revendication 10, **caractérisé en ce que** :

- ledit compteur de puissance électronique (40) est apte à enregistrer des informations connexes à la puissance consommée par ledit système d'éclairage (60) dans une pluralité de plages horaires prédéfinies ;
- lesdits moyens de traitement (10) sont configurés de manière à déterminer ladite pluralité de consommations idéales dans ladite pluralité de plages horaires au cours de ladite période de temps spécifique sur la base d'informations connexes à ladite pluralité de consommations réelles.

Fig. 1

EP 2 676 530 B1

*Fig. 2*

$$Fig. 3$$

*210* — CALCULATE TOTAL HOURS OF OPERATION IN PERIOD P $T_P$

*220* — CALCULATE PERCENTAGE DISTRIBUTION OF MINUTES OF OPERATION IN BANDS $F_1 ... F_N$ $T_{\%F_1} ... T_{\%F_N}$

*230*

CALCULATE ACTUAL CONSUMPTION IN PERIOD P IN BANDS $F_1 ... F_N$ $E_{ACTUAL_{F_1}} ... E_{ACTUAL_{F_N}}$

CHOOSE TIME BAND $F_M$ AND CALCULATE

$$E_{IDEAL_{Fi}} = \frac{E_{ACTUAL_{F_M}}}{T_{\%F_M}} \cdot T_{\%F_i}$$

*240*

CALCULATE DEVIATION $\Delta$

$$\Delta = (E_{ACTUAL_{F_1}} + ... + E_{ACTUAL_{F_N}}) - (E_{IDEAL_{F_1}} + ... + E_{IDEAL_{F_N}})$$

*245*

*250*

$\Delta$ ?

>0 — TWILIGHT SWITCH BROKEN

*270*

<0 — LIGHTING ELEMENTS OR TWILIGHT SWITCH BROKEN

*280*

=0 — TWILIGHT SWITCH IS OPERATING CORRECTLY

*260*

*Fig. 4*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2012287 A2